# EUROPÄISCHE PATENTSCHRIFT

(11) **EP 2 888 629 B1**
(45) Veröffentlichungstag und Bekanntmachung des Hinweises auf die Patenterteilung: **02.03.2016**
(21) Anmeldenummer: 13799316.8
(22) Anmeldetag: 04.12.2013
(51) Int. Cl.: G03F 7/00

(54) **VERFAHREN ZUM MIKROKONTAKTPRÄGEN**
METHOD FOR MICROCONTACT PRINTING
PROCÉDÉ DE POINÇONNAGE DE MICROCONTACTS

(30) Priorität: 10.12.2012 DE 102012112030
(43) Veröffentlichungstag der Anmeldung: 01.07.2015
(73) Patentinhaber: Ev Group E. Thallner GmbH, 4782 St. Florian am Inn (AT)
(72) Erfinder: KREINDL, Gerald, A-4780 Schärding (AT); WIMPLINGER, Markus, A-4910 Ried im Innkreis (AT); CHOUIKI, Mustapha, A-4020 Linz (AT)
(74) Vertreter: Schweiger, Johannes
(86) Internationale Anmeldenummer: PCT/EP2013/075562
(87) Internationale Veröffentlichungsnummer: WO 2014/090661

(56) Entgegenhaltungen:
- WO-A2-2008/115530
- US-A1- 2003 010 241
- US-A1- 2003 127 002
- US-A1- 2008 257 187
- US-A1- 2010 075 108
- US-A1- 2011 126 730
- WEIBEL DOUGLAS B ET AL: "Microfabrication meets microbiology", NATURE REVIEWS. MICROBIOLOGY, NATURE PUBLISHING GROUP, GB, Bd. 5, Nr. 3, 1. März 2007 (2007-03-01), Seiten 209-218, XP002588977, ISSN: 1740-1526, DOI: 10.1038/NRMICRO1616
- ARJAN P QUIST ET AL: "Recent advances in microcontact printing", ANALYTICAL AND BIOANALYTICAL CHEMISTRY, SPRINGER, BERLIN, DE, Bd. 381, Nr. 3, 1. Februar 2005 (2005-02-01), Seiten 591-600, XP019327129, ISSN: 1618-2650, DOI: 10.1007/S00216-004-2847-Z
- CHOI K M ET AL: "A PHOTOCURABLE POLY(DIMETHYLSILOXANE) CHEMISTRY DESIGNED FOR SOFT LITHOGRAPHIC MOLDING AND PRINTING IN THE NANOMETER REGIME", JOURNAL OF THE AMERICAN CHEMICAL SOCIETY, ACS PUBLICATIONS, US, Bd. 125, 1. Januar 2003 (2003-01-01), Seiten 4060-4061, XP002323413, ISSN: 0002-7863, DOI: 10.1021/JA029973K
- JUNHU ZHANG ET AL: "Patterning Colloidal Crystals and Nanostructure Arrays by Soft Lithography", ADVANCED FUNCTIONAL MATERIALS, WILEY - V C H VERLAG GMBH & CO. KGAA, DE, Bd. 20, Nr. 20, 22. Oktober 2010 (2010-10-22), Seiten 3411-3424, XP001558140, ISSN: 1616-301X, DOI: 10.1002/ADFM.201000795
- XIA Y ET AL: "SOFT LITHOGRAPHY", ANNUAL REVIEW OF MATERIALS SCIENCE, ANNUAL REVIEWS INC., PALO ALTO, CA, US, Bd. 28, 1. Januar 1998 (1998-01-01), Seiten 153-184, XP009023786, ISSN: 0084-6600, DOI: 10.1146/ANNUREV.MATSCI.28.1.153

## Beschreibung

Die vorliegende Erfindung betrifft ein Verfahren zum Mikrokontaktprägen gemäß Patentanspruch 1 oder 2.

Der heutige Stand der Technik für die Mirko- und/oder Nanostrukturierung von Oberflächen umfasst vor allem die Photolithographie und die unterschiedlichen Prägetechniken. Die Prägetechniken arbeiten entweder mit harten oder weichen Stempeln. In letzter Zeit setzen sich vor allem die Prägelithographietechniken durch und verdrängen die klassischen Photolithographietechniken. Unter den Prägelithographietechniken wird vor allem die Verwendung von sogenannten weichen Stempeln immer beliebter. Der Grund liegt in der leichten Herstellung der Stempel, effizienten Prägevorgängen, sehr guten Oberflächeneigenschaften der jeweiligen Stempelmaterialien, den geringen Kosten, der Reproduzierbarkeit des Prägeproduktes und vor allem in der Möglichkeit der elastischen verformung des Stempels während der Entformung. In der Softlithographie wird ein Stempel aus einem Elastomer mit einer mikro- bzw. nanotrukturierten Oberfläche verwendet, um Strukturen im Bereich von 20 nm bis >1000 µm herzustellen. Die Prägelithographietechniken können grob in das Hot-Embossing, die Nanoimprintlithographie und das Nano- bzw. Mikrokontaktprägen eingeteilt werden. Beim Hot-Embossing wird der Stempel hauptsächlich unter Anwendung einer Kraft in eine (erwärmte) Prägemasse gedrückt. Bei der Nanoimprintlithographie wird ein sehr fein strukturierter Stempel mit der Prägemasse in Kontakt gebracht. Obwohl auch in diesem Verfahren Kräfte verwendet werden, ist die Aufnahme der Prägemasse in die nano- bzw. mikrometergroßen Strukturen durch kapillarwirkung eine treibende Kraft des Prägeprozesses. Beim Mikrokontaktprägen wird der strukturierte Stempel nicht durch Kraft in eine Prägemasse gedrückt, sondern überträgt eine an der Oberfläche seiner Strukturen befindliche Substanz auf eine andere Oberfläche.

Es gibt sechs bekannte Mikrokontaktprägeverfahren:
- Mikro- und/oder Nanokontaktdrucken (µ/nCP)
- Replikagießen (REM)
- Microtransfer moulding (µTM) oder nanoimprint lithographie (NIL),
- Mikroformung in Kapillaren (MIMIC)
- lösungsmittelunterstützten Mikroformen(SAMIM) und
- Phaseshift Lithographie.

Elastomere Strukturstempel werden als Negativ eines Masters hergestellt. Beim Masterstempel handelt es sich um einen Hartstempel aus Metall oder Keramik, der durch entsprechend aufwendige Prozesse einmal hergestellt wird. Aus dem Master können dann beliebig viele Elastomere Stempel hergestellt werden. Die elastomeren Stempel ermöglichen einen konformen, gleichmäßigen Kontakt über große Oberflächen. Sie sind leicht von ihrem starren Masterstempel, sowie von den Prägeprodukten zu trennen. Weiterhin haben elastomere Stempel eine geringe Oberflächenspannung für eine leichte und einfache Trennung von Stempel und Substrat. Technische Probleme bereiten die Materialkombinationen des Strukturstempels und des Prägematerials, wobei es unter anderem auf eine Langlebigkeit beziehungsweise lange Verwendbarkeit des Strukturstempels und eine exakte Übertragung der Mikro- und/oder Nanostrukturen ankommt.

Aufgabe der vorliegenden Erfindung ist es daher, ein Mikrokontaktdruckverfahren anzugeben, mit welchem ein langlebiger Strukturstempel angegeben wird, der für eine exakte Übertragung der Mikro- und/oder Nanostrukturen auf großen Flächen geeignet ist.

Diese Aufgabe wird mit den Merkmalen der Patentansprüche 1 und 2 gelöst. Vorteilhafte Weiterbildungen der Erfindung sind in den Unteransprüchen angegeben.

Die Erfindung beschreibt ein Verfahren, bei dem zum Mikrokontaktprägen als Prägematerial zumindest überwiegend Silan oder mindestens ein Silanderivat oder eine zumindest überwiegend aus organischen Molekülen bestehende molekulare Komponente verwendet wird.

Die Erfindung betrifft somit eine Methode, die es ermöglicht, Material in einer strukturierten Form direkt und gezielt auf einer Zieloberfläche eines Substrats abzuscheiden. Die Strukturgrößen bewegen sich dabei in lateraler Richtung erfindungsgemäß im Mikrometer- und/oder Nanometer-Bereich. Der Abscheidevorgang beruht auf dem Kontaktierten der Oberfläche mit einem strukturierten Stempel. Dabei wird an dem Strukturstempel haftendes Prägematerial gezielt und in strukturierter Form auf die Zieloberfläche übertragen.

Die Erfindung handelt ferner von der Verwendung eines Strukturstempels aus einem erfindungsgemäß geeigneten Stempelmaterial zur Kontaktprägung einer beliebigen molekularen Komponente.

Eine vorteilhafte Weiterbildung der Erfindung basiert auf einem speziellen Stempelaufbau, der eine automatische Materialzufuhr für das Prägematerial ermöglicht.

Besonders vorteilhaft erweist sich die Anwendung des erfindungsgemäßen Stempelmaterials und/oder des erfindungsgemäßen Stempelaufbaus in Kombination mit, auf das erfindungsgemäße Stempelmaterial abgestimmte Prägematerial auf ausgewählten, erfindungsgemäßen Substratoberflächen und/oder für die Herstellung einer bestimmten Gruppe/Gattung von Endprodukten.

Die Erfindung ermöglicht die Herstellung praktisch beliebig strukturierter Oberflächen mit extrem geringen Dicken aus den vorgenannten, erfindungsgemäßen Komponenten. Die Strukturen werden dabei mit hoher Ausbeute und basierend auf dem einfachen Prozessablauf und der daraus resultierenden geringen Anzahl an Prozessschritten sehr kostengünstig in Massenfertigung erzeugt, da der erfindungsgemäße Strukturstempel für eine Vielzahl von Stempelvorgängen und auf großen Flächen einsetzbar ist. Bei Verwendung der erfindungsgemäßen Stempelstruktur erfolgt die Prägematerialzufuhr für das Prägematerial insbesondere automatisch und/oder kontinuierlich, was wiederum den Durchsatz des Prozesses steigert und die Kosten senkt.

Die offenbarten erfindungsgemäßen Ausführungsformen des Strukturstempels, insbesondere die verwendeten Stempelmaterialien, bieten den Vorteil, das Prägematerial nicht zu verunreinigen, sowie dieses weder aus chemischer Sicht noch aus biologischer Sicht zu verändern oder in ihrer Reaktivität zu beeinflussen. Dabei erlauben die Prägematerialien gleichzeitig einen signifikant verbesserten Herstellungsprozess der für den Kontaktdruck benötigten Stempel.

Die Erfindung betrifft somit ferner eine Methode, eine molekulare Komponente durch einen Kontaktierungsvorgang von einem Strukturstempel auf eine Zieloberfläche eines, insbesondere flächigen, vorzugsweise ebenen, Substrats zu übertragen. In besonderen Ausführungen kann die Übertragung einer molekularen Komponente auch auf eine strukturierte Zieloberfläche erfolgen. Dies erlaubt vor allem die Verwendung des Mikrokontaktprägens zum Aufbau strukturierter Oberflächen in die dritte Dimension. Der Erfindung liegt dabei die Idee zu Grunde, dass ein strukturierter Stempel, welcher aus einem erfindungsgemäß geeigneten Material hergestellt wurde, durch Adhäsionskräfte und/oder Diffusion in das Stempelmaterial eine molekulare Komponente an Erhebungen der Struktur des Strukturstempels fixiert/anhaftet und/oder einen gewissen Bereich in das Stempelmaterial eindiffundiert. Die molekulare Komponente wird an der Oberfläche der Strukturen des Strukturstempels auf eine erfindungsgemäße Zieloberfläche zu bewegt. Durch eine Annäherung des Stempels mit der Zieloberfläche kommt die molekulare Komponente mit der Zieloberfläche in Kontakt. Nach dem Kontakt der Zieloberfläche mit der molekularen Komponente wird letztere auf die Zieloberfläche zumindest teilweise übertragen. Dies ist in jenem Sinne zu verstehen, dass zumindest ein Teil der an den erhabenen Stempelstrukturen anhaftenden Moleküle übertragen wird. Die Mechanismen der Übertragung sind dabei vielfältig.

Die Übertragung einer molekularen Komponente als Struktur auf eine Zieloberfläche bezeichnet man als Kontaktdruck. Im vorliegenden Fall liegen die Dimensionen der zu übertragenden Strukturen im Nano- und/oder Mikrometerbereich, wodurch die Methode präziser als Mikrokontaktdruck bezeichnet wird, der auch Nanokontaktdruck umfasst. Die Methode des Kontaktdruckens weist den Vorteil auf, hauchdünne strukturierte Oberflächen bis hin zu Monolagen herzustellen. Der Technik entsprechend wird also keine Abformung der Stempelstruktur in einer Prägemasse vorgenommen, sondern eine molekulare Komponente, insbesondere Silan und/oder Silanderivate, welche sich zumindest an den Erhebungen des Stempels befindet, übertragen.

In einer Ausführungsform der vorliegenden Erfindung ist vorgesehen, die molekulare Komponente mindestens eines oder mehrere der nachfolgend genannten Strukturen aufweist:
- Enzyme,
- Alkaloide,
- Lipide,
- Hormone,
- Pheromone,
- Vitamine,
- Kohlenhydrate,
- Peptide,
- Nukleinsäuren,
- DNA oder DNA-Stränge,
- Zellen,
- Proteine bzw. Peptide,
- Alkane, Alkene, Alkine, Aromate
- Graphen.

Mit Vorzug handelt es sich um eine Übertragung durch Unterschiede in der Adhäsionskraft zwischen der molekularen Komponente und der Zieloberfläche einerseits und der Adhäsionskraft zwischen der molekularen Komponente und der Stempeloberfläche andererseits. In einer bevorzugten Ausführungsform sind daher die Adhäsionskräfte zwischen der Zieloberfläche und der molekularen Komponente größer als zwischen der Oberfläche des strukturierten Stempels und der molekularen Komponente. Mit Vorzug ist das Verhältnis der eben genannten Adhäsionskräfte größer als 1, mit Vorzug größer als 2, mit größerem Vorzug größer als 5, mit noch größerem Vorzug größer als 10, mit größtem Vorzug größer als 100, mit allergrößtem Vorzug größer als 1000.

Die Ablösung der molekularen Komponente von der Stempeloberfläche kann über eine elektrische Aufladung der Stempeloberfläche erfolgen. Durch die Aufladung der Stempeloblerfläche wird das elektrische Potential so verändert, dass die Adhäsion zur zu übertragenden molekularen Komponente geringer ist als die Adhäsion der molekularen Komponente zur Zieloberfläche. Denkbar wäre auch eine elektrische Aufladung der Zieloberfläche, welche das elektrische Potential dermaßen verändert, dass die Adhäsion zwischen der molekularen Komponente und der Zieloberfläche größer ist als die Adhäsion zwischen der molekularen Komponente und der Stempeloberfläche.

Der Strukturstempel ist zumindest teilweise porös und die Ablösung der molekularen Komponente von der Stempeloberfläche erfolgt vorzugsweise über einen gegenüber der Umgebung erhöhten Druck in den Poren im Inneren des porösen Strukturstempels. Der erhöhte Druck kann dabei durch jede Art von Fluid, daher von Flüssigkeiten und/oder Gasen beaufschlagt werden. Mit Vorzug handelt es sich bei dem Fluid um die abzuscheidende molekulare Komponente, wodurch der Strukturstempel selbst zu einem Reservoir für die molekulare Komponente wird. Das Verhältnis zwischen dem Umgebungsdruck und dem Druck im Stempel ist dabei größer als 1, mit Vorzug größer als 1.5, mit größerem Vorzug größer als 2.0, mit größtem Vorzug größer als 10, mit allergrößtem Vorzug größer als 100.

Die Ablösung der molekularen Komponente kann über einen chemischen Prozess erfolgen, welcher die Kontaktfläche zwischen der molekularen Komponente und der Stempeloberfläche selektiv angreift, während die Kontaktfläche zwischen der molekularen Komponente und der Zieloberfläche nicht angegriffen wird.

Die Ablösung der molekularen Komponente kann über einen thermischen Prozess erfolgen, indem der erfindungsgemäße Stempel auf eine Lösetemperatur erhitzt und/oder ,gekühlt wird, damit sich die molekulare Komponente von der Stempeloberfläche löst, während die Adhäsion zur Zieloberfläche aufrecht erhalten wird.

Die Ablösung der molekularen Komponente über ein elektrisches und/oder magnetisches Feld erfolgen, welches die Kontaktfläche zwischen der molekularen Komponente und der Stempeloberfläche schwächt, während die Adhäsion zur Zieloberfläche aufrecht erhalten wird.

Auch eine Kombination der offenbarten Transferverfahren der molekularen Komponente ist möglich.

Das Prägematerial wird ausschließlich über den Stempel zugeführt. Da ein kontinuierlicher Materialfluss von der Rückseite des Stempels erfolgt, haften immer einige Monolagen der molekularen Komponente übereinander. Die Adhäsion zwischen der molekularen Komponente und der Zieloberfläche ist daher erfindungsgemäß größer als die Kohäsion zwischen den einzelnen Lagen der molekularen Komponente selbst. Dadurch erfolgt die Ablösung der molekularen Komponente zumindest überwiegend in Form von Monolagen.

Der Stempel ist elastisch verformbar, also ein sogenannter "soft-stamp". Ein soft-stamp liegt vor, sobald die Stempelstruktur aus einem weichen Material gefertigt ist. Bevorzugt wird die laterale Stabilität des Soft-Stamps mittels eines dahinter angeordneten, vorzugsweise angebrachten, Trägers gewährleistet. Der Träger ist insbesondere aus Keramik oder Metall gebildet. Die Elastizität wird im Allgemeinen durch einen Steifigkeitstensor definiert. Da die vorliegenden Materialien in guter Näherung homogen-isotropes plastisches Verhalten aufweisen, kann das elastische Verhalten durch die zwei physikalischen Parameter des Elastizitätsmoduls und der Querkontraktionszahl beschrieben werden. Der Elastizitätsmodul der offenbarten Soft-Stamps liegt zwischen 10⁻³ MPa und 100 MPa, mit Vorzug zwischen 10⁻² MPa und 10 MPa, mit größerem Vorzug zwischen 10⁻¹ MPa und 1 MPa, mit größtem Vorzug zwischen 0.5 MPa und 0.8 MPa.

Der E-Modul für PFPE liegt erfindungsgemäß insbesondere zwischen 3 und 40 MPa. Der E-Modul für PDMS liegt erfindungsgemäß bei etwa 0.75 MPa.

Die Querkontraktionszahl liegt zwischen 0.01 und 0.5, mit Vorzug zwischen 0.1 und 0.5, mit größerem Vorzug zwischen 0.2 und 0.5, mit größtem Vorzug zwischen 0.25 und 0.5.

Beim Nano- und/oder Mikrokontaktprägen werden "soft-stamps" bevorzugt, da diese in der Lage sind, sich während des Übertragungsvorganges zu verformen und sich daher an die Welligkeit und/oder Rauigkeit der Zieloberfläche anzupassen. Würde man einen "hard-stamp" verwenden, müssten die Stempeloberflächen, sowie die Zieloberflächen eine extrem geringe Welligkeit- und/oder Rauigkeit aufweisen, die technisch nur sehr schwer oder nur unter hohem Kostenaufwand zu realisieren ist.

Der Strukturstempel ist daher ein "soft-stamp", also ein weicher Stempel. Der Stempel besteht vorzugsweise aus einem leicht abzuformenden, elastischen, säure- und/oder basenresistenten, verschleißfesten, inerten, porösen, kostengünstig herstellbaren Material. Mit Vorzug handelt es sich bei dem Stempelmaterial um ein Polymer. Soweit der Strukturstempel aus einem Polymer gebildet ist, ist dieser insbesondere durch thermische Prozesse und/oder Lichteinstrahlung aushärtbar. Des Weiteren wäre ein Stempel, welcher gleichzeitig als Reservoir für die molekulare Komponente dient, bevorzugt. Das Reservoir wird durch eine entsprechende Porosität des Stempels ermöglicht. Die offene Porosität des Stempels liegt insbesondere zwischen 0 (also: größer 0) und 50%, mit Vorzug zwischen 0 und 40%, mit größerem Vorzug zwischen 0 und 30%, mit größtem Vorzug zwischen 0 und 20%, mit allergrößtem Vorzug zwischen 0 und 10%. Durch die Aufnahme der molekularen Komponente verhält sich der Stempel teilweise wie ein Schwamm. Es kommt zur Aufschwellung des Stempels. Der Materialtransport der molekularen Komponente kann daher von einem sich hinter dem Stempel befindenden Reservoir durch den Stempel erfolgen, oder der Stempel selbst kann durch seine Saugfähigkeit als Reservoir dienen. Die entsprechenden zugrundeliegenden physikalischen Phänomene des Materialtransports im und/oder durch den Stempel sind daher die Diffusion und die Grundgesetze der Strömungsdynamik. Diffusion erfolgt dabei bereits dann, wenn die molekulare Komponente in der Lage ist, von einer Seite des Stempels zur anderen Seite zu gelangen, beziehungsweise von einer Seite des Stempels, wie von einem Schwamm, aufgesogen zu werden. In Spezialfällen kann die Diffusion auch dann vorliegen, wenn die Porosität des Stempels verschwindend gering ist, die molekulare Komponente allerdings auf Grund der Mikrostruktur des Stempelmaterials dennoch die Möglichkeit bekommt, sich zu bewegen.

In einer besonderen Ausführungsform besteht der Stempel aus einem Perfluoropolyether (PFPE).

In einer weiteren besonderen Ausführungsform besteht der Stempel aus einem Polydimethlysiloxan (PDMS).

Der Strukturstempel ist mit Vorzug transparent, um die abzuscheidende molekulare Komponente durch den Strukturstempel hindurch mit elektromagnetischer Strahlung zu beaufschlagen, insbesondere um kurz vor und/oder während und/oder nach der Übertragung des Prägematerials auf die Zieloberfläche entsprechende physikalische und/oder chemische Prozesse zu starten. Dis gilt analog für die thermische Leitfähigkeit, die elektrische Leitfähigkeit, die Primitivität und Permeabilität, sollten die genannten chemischen und/oder physikalischen Prozesse durch Wärme, elektrischen Strom, elektrische Felder oder magnetische Felder gestartet werden.

Der Strukturstempel ist erfindungsgemäß entweder ein durch x-y-z-Translation im Raum bewegbarer Strukturstempel oder ein Rollenstempel. Unter einem Rollenstempel versteht man eine, mit Vorzug nahtlos, strukturierte, Rolle, welche ihre Oberflächenstruktur durch eine rotatorische Bewegung auf die Zieloberfläche überträgt und zur Herstellung von "Endlosprodukten" geeignet ist.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen jeweils in schematischer Ansicht:
- Figur 1: eine schematische Querschnittsansicht einer ersten Ausführungsform der vorliegenden Erfindung,
- Figur 2: eine schematische Querschnittsansicht einer zweiten Ausführungsform der vorliegenden Erfindung,
- Figur 3: eine schematische Querschnittsansicht einer dritten Ausführungsform der vorliegenden Erfindung,
- Figur 4: eine schematische Querschnittsansicht einer vierten Ausführungsform der vorliegenden Erfindung,
- Figur 5: eine schematische Querschnittsansicht einer fünften Ausführungsform der vorliegenden Erfindung, und
- Figur 6: eine schematische Querschnittsansicht einer sechsten Ausführungsform der vorliegenden Erfindung.

In den Figuren sind Vorteile und Merkmale der Erfindung mit diese jeweils identifizierenden Bezugszeichen gemäß Ausführungsformen der Erfindung gekennzeichnet, wobei Bauteile beziehungsweise Merkmale mit gleicher oder gleichwirkender Funktion mit identischen Bezugszeichen gekennzeichnet sind.

In den Figuren sind die erfindungsgemäßen Merkmale nicht maßstabsgetreu dargestellt, um die Funktion der einzelnen Merkmale überhaupt darstellen zu können. Auch die Verhältnisse der einzelnen Bauteile sind teilweise unverhältnismäßig, was insbesondere auf stark vergrößert dargestellte Strukturen 2 und Poren 5 zurückzuführen ist. Die Strukturen 2, die mit der vorliegenden Erfindung geprägt werden beziehungsweise zum Prägen von korrespondierenden Nanostrukturen auf Werkstücke verwendet werden, liegen im Nano- und/oder Mikrometerbereich, während die Größenordnung der Maschinenbauteile im Zentimeterbereich liegt.

Die Abmessungen der einzelnen Strukturen 2 einer Prägefläche 2o eines Strukturstempels 1 liegen vorzugsweise im Mikrometer- und/oder im Nanometerbereich. Die Abmessungen der einzelnen Strukturen 2 sind kleiner als 1000 µm, mit Vorzug kleiner als 10 µm, mit größerem Vorzug kleiner als 100 nm, mit noch größerem Vorzug kleiner als 10 nm, mit allergrößtem Vorzug kleiner als 1 nm.

Die Erfindung ist in den Ansprüchen definiert.

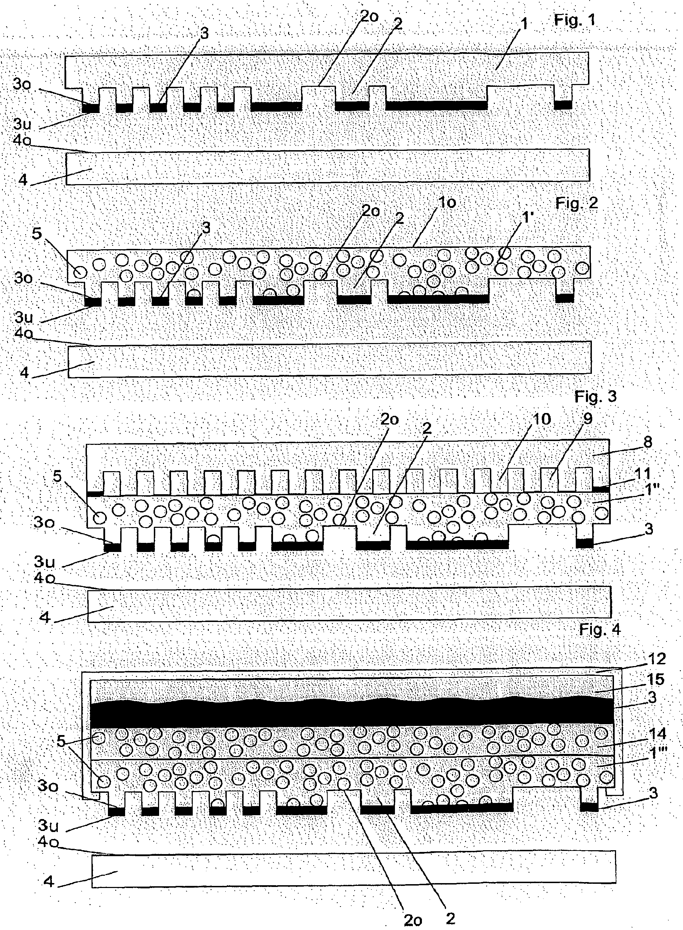

Bei den in Figuren 1 bis 4 gezeigten Ausführungsformen sind Strukturstempel 1, 1', 1", 1"' gezeigt, die durch Linearbewegung mit einer Zieloberfläche 4o eines Substrats 4 kontaktiert werden.

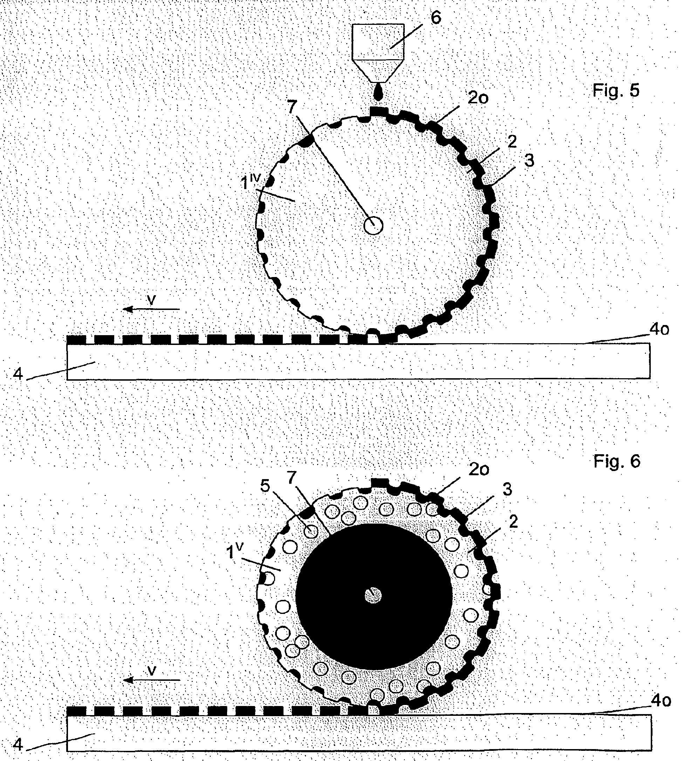

Bei den in Figuren 5 und 6 gezeigten Ausführungsformen sind Strukturstempel 1^{IV}, 1^{V} gezeigt, die durch Rotationsbewegung um eine Rotationsachse der Strukturstempel 1 mit einer Zieloberfläche 4o eines Substrats 4 kontinuierlich durch Abrollen entlang der Zieloberfläche 4o kontaktiert werden.

Figur 1 zeigt eine erfindungsgemäße erste Ausführungsform des, vorzugsweise aus PFPE gefertigten, Strukturstempels 1 mit Strukturen 2, an deren Prägefläche 2o ein Prägematerial 3 haftet. Das Prägematerial 3 besitzt eine der Prägefläche 2o zugewandte erste Oberfläche 3o und eine einer Zieloberfläche 4o des Substrats 4 zugewandte zweite Seite 3u. Das Prägematerial 3 wird vorher in einem nicht gezeigten Beschichtungsschritt durch Eintauchen der Strukturen 2 in ein Reservoir des, insbesondere flüssigen, Prägematerials 3 auf die Prägefläche 20 aufgebracht.

Figur 2 zeigt eine erfindungsgemäße zweite Ausführungsform des, vorzugsweise aus PFPE gefertigten, Strukturstempels 1', der sich durch seine Poren 5 vom Strukturstempel 1 unterscheidet. Die Poren 5 haben eine offene Porosität, sodass der Fluidtransport des Prägematerials 3 von einer zur Prägefläche 2o abgewandten Rückseite 1o des Stempels 1' zur Prägefläche 2o der Strukturen 2 erfolgen kann.

Figur 3 zeigt eine erfindungsgemäße dritte Ausführungsform eines, vorzugsweise aus PFPE gefertigten, Strukturstempels 1", der sich vom Stempel 1' durch eine Folie 8 unterscheidet, die an seiner Rückseite 1o angebracht wurde. Die Folie 8 besitzt Erhebungen 10, welche Hohlräume 9 voneinander trennen. Die Hohlräume 9 dienen der Aufnahme des Prägematerials 3, welches durch den Stempel 1" diffundieren und so an die Prägefläche 2o der Strukturen 2 gelangen kann. Die Erhebungen 10 können insbesondere Säulen oder Stempel (pillars) oder langgezogene, über die gesamte Breite verlaufende Wände sein. Die Erhebungen 10 dienen vorwiegend der Unterstützung des Stempels 1". Die Folie 8 besitzt eine Dicke zwischen 100 und 2000µm. Die Höhe der Hohlräume 9 bzw. Höhe der Erhebungen 10 beträgt zwischen 100µm und 500µm. Die Folie 8 ist vorzugsweise an einem Seitenumfang 11 der Folie 8 und des Strukturstempels 1 mit dem Stempel 1" verbunden. Es kann sich hierbei um eine Verklebung, Verschweißung oder eine anderweitige, mit Vorzug unlösbare, Verbindungsart handeln.

Figur 4 zeigt eine erfindungsgemäße vierte Ausführungsform eines Stempels 1 "', der an einen Träger 14 montiert ist, welcher mit Vorzug ebenfalls porös ist. Der Träger 14 besteht mit Vorzug aus einer Keramik oder einem Metall oder aus einem hochfesten und harten Polymer. Der Stempel 1"' und der Träger 14 sind von einer Abschirmung 12 umgeben. In einem Hohlraum 15 über dem Träger 14 kann das Prägematerial 3 gespeichert werden. Die Diffusion der molekularen Komponente 3 durch die Stützplatte 14 und den Stempel 1"' erfolgt sinngemäß wie in den anderen genannten Ausführungsformen. Der Träger 14 kann mit dem Stempel 1"' verbunden sein, indem das Material des Stempels 1"' sich in die poröse Struktur des Trägers 14 bewegt oder während des Herstellungsprozesses der Verbindung hineingezwungen wird. Da das Material des Stempels 1"' mit Vorzug sehr weich ist, kann der Stempel 1"' beispielsweise auf dem Träger 14 hergestellt werden. Während des Herstellprozesses kann die hochviskose, aber immer noch flüssige Prägemasse, aus welcher der Stempel 1"' hergestellt wird, teilweise bereits in die Poren des Trägers 14 eindringen und stellt damit eine Verbindung zwischen beiden Elementen her. Nach der Aushärtung der Prägemasse des Stempels 1'' ist dieser fest mit dem Stempel 14 verbunden. Erfindungsgemäß müssen der Träger 14 und der Stempel 1"' allerdings nicht miteinander verbunden sein, sondern können auch nur durch die Abschirmung 12 oder jede beliebige andere Vorrichtung aneinander gepresst werden oder zumindest zusammengehalten werden.

Figur 5 zeigt eine erfindungsgemäße fünfte Ausführungsform eines Strukturstempels 1^{IV} in Form einer, vorzugsweise aus PFPE gefertigten Rolle 1, welche als Rundstempel betrachtet werden kann. Ein Dispenser 6 sorgt für eine, insbesondere kontinuierliche und andauernde, Benetzung der Prägefläche 2o der Strukturen 2 mit dem Prägematerial 3. Durch eine entsprechende Relativbewegung eines Substrats 4 zum Strukturstempel 1^{IV} erfolgt die Übertragung des Prägematerials 3 auf die Zieloberfläche 4o. In der bevorzugtesten Ausführungsform wird der Strukturstempel 1^{IV} um eine Rotationsachse 7 rotierbar gelagert, während das Substrat 4 mit einer Geschwindigkeit v translatorisch beziehungsweise tangential zur Rolle bewegt wird.

Figur 6 zeigt eine erfindungsgemäße sechste Ausführungsform eines Strukturstempels 1^{IV} in Form einer, vorzugsweise aus PFPE gefertigten Rolle 1, welche als Rundstempel betrachtet werden kann. Der Strukturstempel 1^{V} ist als Hohlwelle gefertigt. Ein Hohlraum im Inneren der Hohlwelle dient als Reservoir für das Prägematerial 3. Der Strukturstempel 1^{V} besitzt eine poröse Mikrostruktur aus Poren 5, welche den Durchgang des Prägematerials 3 vom Hohlraum an die Oberfläche 2o der Strukturen 2 erlaubt. Durch eine der fünften Ausführungsform entsprechende Relativbewegung eines Substrats 4 zur Rolle erfolgt die Übertragung der molekularen Komponente 3 auf die Zieloberfläche 4

### Bezugszeichenliste

- 1, 1', 1", 1"',: Strukturstempel
- 1^{1V}, 1^{V}: Strukturstempel
- 1o: Rückseite
- 2: Strukturen
- 2o: Prägefläche
- 3: Prägematerial
- 3o: erste Seite
- 3u: zweite Seite
- 4: Substrat .
- 4o: Zieloberfläche
- 5: Poren
- 6: Dispenser
- 7: Rotationsachse
- 8: Folie
- 9: Hohlräume
- 10: Erhebungen
- 11: Seitenumfang
- 12: Abschirmung
- 14: Träger
- 15: Hohlraum
- V: Geschwindigkeit

## Patentansprüche

1. Verfahren zum Mikrokontaktprägen einer Struktur durch Übertragung eines Prägematerials (3) auf eine Zieloberfläche (4o) eines Substrats (4) mittels einer Prägefläche (2o) eines Strukturstempels (1), **dadurch gekennzeichnet, dass** das Prägematerial (3) zumindest überwiegend aus Silan oder zumindest überwiegend aus mindestens einem Silanderivat besteht oder eine zumindest überwiegend aus organischen Molekülen bestehende molekulare Komponente ist und dass der Strukturstempel (1) ein weicher Stempel ist, wobei der Strukturstempels (1) in Form einer Rolle als Hohlwelle gefertigt ist, wobei der Hohlraum im Inneren der Hohlwelle als Reservoir für das Prägematerial (3) dient, wobei der Strukturstempels (1) eine poröse Mikrostruktur aus Poren (5) besitzt, welche den Durchgang des Prägematerials (3) vom Hohlraum an die Oberfläche (2o) von Strukturen (2) erlaubt.

2. Verfahren nach Anspruch 1, bei dem die molekulare Komponente mindestens eines oder mehrere der nachfolgend genannten Strukturen aufweist:
- Enzyme,
- Alkaloide,
- Lipide,
- hormone.
- Pheromone,
- Vitamine,
- Kohlenhydrate,
- Peptide,
- Nukleinsäuren,
- DNA oder DNA-Stränge,
- Zellen,
- Proteine bzw. Peptide,
- Alkane, Alkene, Alkine, Aromate
- Graphen.

3. Verfahren nach einem der vorhergehenden Ansprüche, bei dem der Strukturstempel (1) eine Elastizität/ein Elastizitätsmodul von 10⁻³ MPa und 100 MPa, mit Vorzug zwischen 10⁻² MPa und 80 MPa, mit größerem Vorzug zwischen 10⁻¹ MPa und 60 MPa, mit größtem Vorzug zwischen 3 MPa und 40 MPa aufweist.

4. Verfahren nach einem der vorhergehenden Ansprüche, bei dem der Strukturstempel (1) säure- und/oder basenresistent ist.

5. Verfahren nach einem der vorhergehenden Ansprüche, bei dem der Strukturstempel (1) zumindest überwiegend, vorzugsweise vollstandig aus einem inerten Material besteht.

6. Verfahren nach einem der vorhergehenden Ansprüche, bei dem der Strukturstempel (1) aus einem Polymer, insbesondere PFPE oder PDMS, gebildet ist.

## Claims

1. Method for microcontact embossing of a structure by transfer of an embossing material (3) onto a target surface (4o) of a substrate (4) by means of an embossing surface (2o) of a structural die (1), **characterized in that** the embossing material (3) consists at least predominantly of silane or at least predominantly of at least one silane derivative or is a molecular component that consists at least predominantly of organic molecules and **in that** the structural die (1) is a soft die, wherein the structural die (1) is formed in the shape of a roller as a hollow shaft, wherein the cavity in the interior of the hollow shaft is used as a reservoir for the embossing material (3), wherein the structural die (1) has a porous microstructure that consists of pores (5) and that makes possible the passage of the embossing material (3) from the cavity to the surface (2o) of structures (2).

2. Method according to Claim 1, in which the molecular component has at least one or more of the structures mentioned below:
- Enzymes,
- Alkaloids,
- Lipids,
- Hormones,
- Pheromones,
- Vitamins,
- Carbohydrates,
- Peptides,
- Nucleic acids,
- DNA or DNA strands,
- Cells,
- Proteins or peptides,
- Alkanes, alkenes, alkines, aromatic compounds
- Graphene.

3. Method according to one of the preceding claims, in which the structural die (1) has an elasticity/a modulus of elasticity of 10⁻³ MPa and 100 MPa, preferably between 10⁻² MPa and 80 MPa, more preferably between 10⁻¹ MPa and 60 MPa, and most preferably between 3 MPa and 40 MPa.

4. Method according to one of the preceding claims, in which the structural die (I) is acid-resistant and/or base-resistant.

5. Method according to one of the preceding claims, in which the structural die (1) consists at least predominantly, preferably completely, of an inert material.

6. Method according to one of the preceding claims, in which the structural die (1) is formed from a polymer, in particular PFPE or PDMS.

## Revendications

1. Procédé de matriçage par micro-contact d'une structure par transfert d'un matériau de matriçage (3) sur une surface cible (40) d'un substrat (4) au moyen d'une surface de matriçage (20) d'un poinçon de structure (1), **caractérisé en ce que** le matériau de matriçage (3) est composé majoritairement de silane ou au moins majoritairement d'au moins un dérivé de silane, ou est une composante moléculaire composée au moins majoritairement de molécules organiques, et que le poinçon de structure (1) est un poinçon souple, sachant que le poinçon de structure (1) est fabriqué sous forme d'un rouleau en tant qu'arbre creux, sachant que l'espace creux à l'intérieur de l'arbre creux sert de réservoir pour le matériau de matriçage (3), sachant que le poinçon de structure (1) possède une microstructure poreuse faite de pores (5) qui permet le passage du matériau de matriçage (3) de l'espace creux à la surface (20) de structures (2).

2. Procédé selon la revendication 1, dans lequel la composante moléculaire présente au moins une ou plusieurs des structures listées ci-après :
- enzymes
- alcaloïdes
- lipides
- hormones
- phéromones
- vitamines,
- hydrates de carbone
- peptides
- acides nucléiques
- ADN ou chaînes d'ADN,
- cellules
- protéines, respectivement peptides,
- alcanes, alcènes, alkynes, aromates,
- graphes.

3. Procédé selon l'une des revendications précédentes, dans lequel le poinçon de structure (1) présente une élasticité/un module d'élasticité de 10⁻³ MPa et 100 MPa, de préférence entre 10⁻² MPa et 80 MPa, avec une plus grande préférence entre 10⁻¹ MPa et 60 MPa, de façon la plus préférée entre 3 MPa et 40 MPa.

4. Procédé selon l'une des revendications précédentes, dans lequel le poinçon de structure (1) est résistant aux acides et/ou aux bases.

5. Procédé selon l'une des revendications précédentes, dans lequel le poinçon de structure (1) est composé majoritairement, de préférence intégralement, d'un matériau inerte.

6. Procédé selon l'une des revendications précédentes, dans lequel le poinçon de structure (1) est fabriqué dans un polymère, en particulier en PFPE ou en PDMS.
